# EUROPÄISCHE PATENTSCHRIFT

(11) **EP 2 568 058 B1**
(45) Veröffentlichungstag und Bekanntmachung des Hinweises auf die Patenterteilung: **17.12.2014**
(21) Anmeldenummer: 11007363.2
(22) Anmeldetag: 09.09.2011
(51) Int. Cl.: C23C 14/06, C23C 14/54, F16G 13/00

(54) **Gelenkkette mit hartstoffbeschichteten Kettengelenken**
Articulated chain with hard coated chain links
Chaîne articulée dotée d'articulations à chaînes revêtues d'un matériau dur

(43) Veröffentlichungstag der Anmeldung: 13.03.2013
(73) Patentinhaber: iwis motorsysteme GmbH & Co. KG, 81369 München (DE)
(72) Erfinder: Jörgensen, Gerald, 82256 Fürstenfeldbruck (DE); Belmer, Stefan, 85646 Anzing (DE)
(74) Vertreter: Grünecker, Kinkeldey, Stockmair & Schwanhäusser

(56) Entgegenhaltungen:
- EP-A1- 1 219 861
- EP-A1- 1 635 087
- EP-A1- 1 980 642
- EP-A1- 2 192 327
- WO-A1-02/40734
- DE-U1-202006 020 978

## Beschreibung

Die Erfindung betrifft eine Gelenkkette aus jeweils mittels eines Kettengelenks miteinander verbundenen Kettengliedern, wobei das Kettengelenk mindestens ein Kettengelenklager und einen in dem Gelenklager verschwenkbar geführten und mit diesem in Kontakt stehenden Bolzen umfasst, wobei zumindest eine Lagerfläche des Bolzens und/oder des Gelenklagers mit einer Hartstoffschicht versehen ist, und die Hartstoffschicht mittels eines PVD-Prozesses aufgebracht ist.

Gelenkketten mit jeweils über ein Kettengelenk miteinander verbundenen Kettengliedern sind in vielfältiger Form im Stand der Technik im Einsatz. Im überwiegenden Umfang handelt es sich um Ketten, bei denen sich jeweils ein Innenkettenglied aus zwei parallelen Innenlaschen mit einem Außenkettenglied, das aus zwei mittels zwei Gelenkbolzen miteinander verbundenen Außenlaschen besteht, abwechselt. Ein Kettengelenk ist dabei mittels eines Kettenbolzens und den darauf verschwenkbaren Laschen des Innenkettenglieds gebildet. Sofern es sich um eine Kette mit Gelenkhülsen handelt, so wird das Kettengelenk durch die Gelenkhülse und den hindurchgeführten verschwenkbar gelagerten Gelenkbolzen gebildet.

Im Einsatz als Antriebs- oder Förderketten wird insbesondere der Bereich der Kettengelenke stark beansprucht, so dass hier ein starker Bedarf bezüglich einer verschleißbeständigen Lagerfläche besteht. Neben dem Einsatz als Antriebs- oder Förderketten werden Gelenkketten wieder in zunehmendem Maße in der Automobilindustrie zur Steuerung des Ventiltriebs von Verbrennungsmotoren genutzt. Dabei sind die Anforderungen an die Verschleißbeständigkeit besonders hoch, da in Verbrennungsmotoren sehr häufige Lastwechsel vorliegen und lediglich ein sehr eingeschränkter Zugang zur Wartung oder Austausch der Kette gegeben ist. Zudem wird angestrebt, die Kette möglichst klein und leicht zu konstruieren, was die Belastung der einzelnen Kettenelemente weiter erhöht.

Um die notwendige Verschleißbeständigkeit zu erreichen und eine verschleißbedingte Längung zu vermeiden, werden die Gelenkbolzen und/oder Gelenkhülsen herkömmlicher Gelenkketten einer Wärmebehandlung unterzogen, z. B. Vergüten, Karborieren, Karbonitrieren, etc. oder mit einer Karbidschicht versehen. Trotz einer Wärmebehandlung der Gelenkbauteile und/oder der Ausbildung einer Carbidschicht auf den Gelenkflächen, treten insbesondere beim Einsatz als Steuerketten in einem Verbrennungsmotor Verschleißprobleme und eine verschleißbedingte Längung auf, die die Zuverlässigkeit des Motors verringern oder einen kostspieligen Wechsel der Kette erforderlich machen .

Eine gattungsgemäße Gelenkkette ist aus der DE 10 2006 052 869 A1 bekannt. Darin ist eine Gelenkkette offenbart, deren Gelenkbolzen und/oder Gelenkhülse mit einer PVD-Hartstoffschicht versehen ist, wobei der Gelenkbolzen und/oder die Gelenkhülse aus einem Basismaterial aus hochkohlenstoffhaltigem Stahl mit einem Kohlenstoffgehalt zwischen 0,4 Gew.-% und 1,2 Gew.-% besteht, das die PVD-Hartstoffschicht trägt. Die offenbarte PVD-Hartstoffschicht kann sowohl aus metallischen Hartstoffen als auch aus nicht-metallischen Hartstoffen bestehen. Als metallische Hartstoffe kommen alle Carbide, Nitride, Karbonitride, Boride und Silizide der Übergangsmetalle in Frage. Als nichtmetallische Hartstoffe kommen beispielsweise Diamant und DLC (diamond like carbon) sowie Korund, Borkarbid, kubisches Bornitrid, Siliciumkarbid oder Aluminiumnitrid in Frage. EP 2 192 327 A1 offenbart Kettenbolzen für eine Gelenkkette, die mit Hartstoffschichten aus Metallkarbiden beschichtet sind.

Derartige Hartstoffschichten stellen hinsichtlich der zuvor genutzten Beschichtungsverfahren eine Verbesserung dar. Dennoch besteht aufgrund der vorgenannten hohen Belastungen sowie des Trends zur kleineren Dimensionierung von Motoren bei gleichzeitiger Leistungszunahme ein Bedarf an noch höher belastbaren Ketten.

Des Weiteren besteht bei PVD-Verfahren ein Problem darin, dass sich das Beschichtungsmaterial nicht nur auf den zu beschichtenden Gegenständen, sondern auch in der Beschichtungsanlage niederschlägt. Beim PVD-Verfahren (Physical Vapor Deposition), werden sogenannte Targets genutzt, die aus dem Material bestehen, das auf dem zu beschichtenden Bauteil abgeschieden werden soll. Mittels verschiedener Verfahren kann aus diesem Target das Beschichtungsmaterial gelöst werden, so dass es als gasförmiger Teilchenstrom auf die Oberfläche des zu beschichtenden Bauteils gelangt und eine Beschichtung ausbildet. Hierbei ist es einerseits gewünscht, dass die Targets lediglich aus den Elementen bestehen, die später auch auf dem Endprodukt abgeschieden werden sollen. Zudem ist es ein Ziel, die Materialkombinationen, die später auf dem Endprodukt abgeschieden sind, in geringer Anzahl zu halten. Dies erleichtert die Zusammenstellung bzw. Produktion der Targets und minimiert damit auch die Komplexität der ungewünschten Verunreinigung der Beschichtungskammer.

Es ist deshalb Aufgabe der Erfindung, eine Gelenkkette hinsichtlich ihrer Verschleißeigenschaften weiterzubilden und zudem ein Beschichtungsverfahren anzugeben, das gegenüber bisherigen Beschichtungsverfahren verbessert ist.

Die Aufgabe wird mit einer Gelenkkette des Anspruchs 1 sowie mit einem Verfahren zum Beschichten einer Lagerfläche nach Anspruch 12 gelöst.

Der Bolzen bildet mit dem Gelenklager eine Reibpaarung. Zur Verringerung der Reibung im Gelenklager mit Hilfe der Hartstoffschicht ist es ausreichend, dass eines der beiden Elemente, d.h. der Bolzen oder das Gelenklager mit der Hartstoffschicht versehen sind. Ebenso können auch beide beschichtet sein. Die Hartstoffschicht besteht aus einer Verbindung, die mindestens drei Stoffe umfasst. Dies sind ein erstes und ein zweites Metall sowie ein Nichtmetall. Das Nichtmetall ist aus der Gruppe von Kohlenstoff (C), Stickstoff (N) oder Silizium (Si) ausgewählt. Das erste und das zweite Metall sind ausgewählt aus den Stoffen Chrom (Cr), Molybdän (Mo), Vanadium (V), Wolfram (W), Titan (Ti), Kupfer (Cu), Zink (Zn), Zirkonium (Zr), Tantal (Ta), Niob (Nb), Aluminium (Al), Bor (B) und Hafnium (Hf).

Das erste und zweite Metall unterscheiden sich dabei voneinander. Das erste und das zweite Metall bilden in der Hartstoffschicht kristalline Strukturen aus. Dabei sind das erste Metall und das zweite Metall derart ausgewählt, dass diese sich in der Hartstoffschicht in Verbindung mit dem Nichtmetall in ihren Kristallstrukturen unterscheiden. Als typische Kristallstrukturen für Metalle sind die kubisch flächenzentrierte Kristallstruktur (kfz), die hexagonale Kristallstruktur (hex) und die tetragonale Kristallstruktur (tetr) bekannt.

Es hat sich gezeigt, dass sich derartige Kombinationen eines Nichtmetalls mit zwei Metallen, die sich jeweils in ihrer Kristallstruktur unterscheiden zu einer Schicht mit sehr hoher Härte führt. Dies lässt sich darauf zurückführen, dass sich keine homogene Schichtzusammensetzung ergibt, sondern dass einzelne Defekte im Schichtaufbau vorliegen, wodurch ein sogenannter Kristallmissmatch mit einer Aufhärtung und/oder Kornfeinung vorliegt. Es ergibt sich also eine Erzeugung von wechselnden Kombinationen von Kristallstrukturen der einzelnen Stoffphasen in der Schicht: z.B. kubische mit hexagonalen oder tetragonalen Strukturen, kubisch raumzentrierte mit kubisch flächenzentrierten Strukturen. Alternativ kann vorgesehen sein, dass eines der Nichtmetalle, Kohlenstoff, Stickstoff oder Silizium der maßgebliche Reaktionspartner ist. Dies kann durch die Bereitstellung der jeweiligen Menge eines Stoffes gesteuert werden.

Ferner kann vorgesehen sein, dass die Hartstoffschicht einen gradierten Aufbau hinsichtlich des Nichtmetallanteils, der Härte oder des Eigenspannungsanteils aufweist. Dabei ist der Begriff "gradiert" derart zu verstehen, dass dieser nicht nur den Aufbau einer Beschichtung aus verschiedenen, voneinander abgrenzbaren Schichten bezeichnet. Auch innerhalb einer Schicht kann stoffbezogen eine ungleichmäßige Verteilung vorliegen. Des Weiteren ist eine gradierte Lage vorstellbar, in die eine weitere Lage eingeschoben ist, d.h. die Gradierung erstreckt sich über die gesamte Beschichtung, wird jedoch von einer zweiten Lage unterbrochen. Des Weiteren ist vorstellbar, dass eine gradierte Lage in der Beschichtung mit einer zweiten Lage des zweiten Metalls abgedeckt ist, worauf dann erneut eine neue eigenständig gradierte Lage des ersten Metalls angeschlossen ist. Wie bereits angesprochen, kann sich die Gradierung auch hinsichtlich der Härte oder des Eigenspannungsanteils auswirken. Dies bedeutet, dass die Härte in der Hartstoffschicht ortsabhängig unterschiedliche Werte aufweist.

Denkbar ist ferner, dass als Basiswerkstoff des Bolzens oder des Gelenklagers ein Crlegierter Stahl, z.B. 59CrV4 oder 100Cr6 gewählt ist. Diese Metalle haben sich als gute Basis für derartige Beschichtungen erwiesen.

Eine denkbare Ausgestaltung der Gelenkkette besteht darin, die Schichtdicke der Hartstoffschicht im Bereich von 1 bis 15 µm zu wählen, bevorzugt 1 bis 10 µm. Eine solche Schichtdicke bietet eine ausreichende Schutzschicht bei dauerhafter Belastung und ist nicht zu dünn.

Ferner kann vorgesehen sein, dass eine Schichtlagendicke der Hartstoffschicht weniger als 1 µm, bevorzugt weniger als 0,5 µm, beträgt. Sofern die Hartstoffschicht also aus einzelnen, voneinander unterscheidbaren Schichtlagen ausgebildet ist, so sollten diese weniger als 1 µm, bevorzugt weniger als 0,5 µm, betragen. Auf diese Weise wird sichergestellt, dass ein Ablösen bzw. Abplatzen von einzelnen Schichten verhindert wird.

Weiter ist denkbar, dass die gradierten Korngrößen der Hartstoffschicht eine Größe von kleiner oder gleich 100 nm, bevorzugt von kleiner oder gleich 50 nm, aufweisen. Sofern einzelne Korngrößen in der Hartstoffschicht erkennbar sind, so haben sich diese Größenbereiche für die Härte und Dauerfestigkeit der Hartstoffschicht als bevorzugt herausgestellt.

Weiter ist denkbar, dass die Hartstoffschicht zumindest bereichsweise eine glasähnliche Struktur aufweist. Als glasähnlich ist dabei zu verstehen, dass die Atome keine geordneten Strukturen, sondern ein unregelmäßiges Muster bilden und lediglich über eine Nahordnung, nicht aber eine Fernordnung verfügen. Derartige glasähnliche Strukturen, die aus den für die Hartstoffschicht genutzten Stoffen zusammengesetzt sind, weisen eine hohe Stabilität sowie Dauerfestigkeit auf und sind deshalb eine der angestrebten Ausgestaltungen.

Alternativ kann vorgesehen sein, dass die gradierten Schichthärten der Hartstoffschicht von 2000 bis 4000 HV oder 4000 bis 7000 HV liegen. Diese Bereiche der Schichthärten sind in den üblicherweise anfallenden Einsatzbedingungen für derartige Gelenkketten bevorzugt.

Ferner ist denkbar, dass die Hartstoffschicht mittels eines kontinuierlichen PVD-Verfahrens im Durchlaufverfahren aufgebracht ist. Durchlaufverfahren unterscheiden sich von Batch-Verfahren dadurch, dass die zu beschichtenden Bauteile kontinuierlich in die Beschichtungskammer eingebracht und aus dieser entfernt werden, z.B. mittels eines Förderbandes. Es befinden sich also ständig Bauteile in der Beschichtungskammer, wobei sich die Bauteile in verschiedenen Stadien des Beschichtungsprozesses befinden. Bei Batch-Verfahren hingegen wird eine gewisse Anzahl an Bauteilen zusammen in die Kammer eingebracht und nach dem Beschichten wieder entfernt. Es ergeben sich deshalb Zeiträume in denen sich keine Bauteile in der Beschichtungskammer befinden. Zudem befinden sich bei Batch-Verfahren alle Bauteile immer im gleichen Stadium des Beschichtungsprozesses. Das Durchlaufverfahren ermöglicht einen wesentlich höheren Durchsatz und ist daher aus wirtschaftlichen Gründen zu bevorzugen.

Ferner wird die erfindungsgemäße Aufgabe durch einen Kettenbolzen für eine Gelenkkette gelöst, der zumindest bereichsweise mit einer Hartstoffschicht der zuvor vorgestellten Art versehen ist.

Weiter wird die erfindungsgemäße Aufgabe durch ein Verfahren zum Beschichten einer Lagerfläche eines Bolzens und/oder eines Gelenklagers für eine Kette mit einer Hartstoffschicht gelöst, wobei die Hartstoffschicht mittels eines PVD-Prozesses aufgebracht ist und aus einer Verbindung gebildet ist, die mindestens ein erstes und ein zweites Metall und ein Nichtmetall umfasst, wobei als Nichtmetall zumindest einer der Stoffe aus Kohlenstoff, Stickstoff oder Silizium ausgewählt ist und das erste Metall und das zweite Metall aus den Stoffen Chrom, Molybdän, Wolfram, Kupfer, Zink, Zirkonium, Tantal, Niob, Aluminium, Bor, Vanadium und Hafnium ausgewählt sind, wobei sich das erste und das zweite Metall voneinander unterscheiden, und das erste Metall in Verbindung mit dem Nichtmetall in der Hartstoffschicht eine Kristallstruktur ausbildet, die sich von der Kristallstruktur des zweiten Metalls in Verbindung mit dem Nichtmetall unterscheidet.

Alternativ kann vorgesehen sein, dass die Hartstoffschicht in einem gradierten Aufbau aufgebracht ist.

Ferner kann vorgesehen sein, dass der PVD-Prozess als kontinuierlicher Prozess im Durchlaufverfahren abläuft.

Weiter kann vorgesehen sein, dass die zu beschichtenden Bauteile während des Beschichtungsvorgangs derart in einem Beschichtungsraum geführt werden, dass diese zumindest bereichsweise im zeitlichen Verlauf unterschiedlichen Temperaturen ausgesetzt sind. Neben der Auswahl der richtigen Stoffkombinationen kann auch die Variation der Temperaturen in gewissem Maße dazu benutzt werden, die Bildung unterschiedlicher Kristallstrukturen zu unterstützen. Das Beschichtungsverfahren ist deshalb derart angepasst, dass selbst bei einer angenommen gleichbleibenden Zuführung der einzelnen Stoffe aufgrund der Variation der Temperatur sich dennoch unterschiedliche Kristallstrukturen ausbilden.

Als weitere Variante kann vorgesehen sein, dass das erste Metall aus einer ersten Gruppe und das zweite Metall aus einer zweiten Gruppe ausgewählt sind, wobei mindestens ein Metall der ersten Gruppe mit mindestens einem Metall der zweiten Gruppe kombiniert ist, und die erste Gruppe Chrom, Molybdän, Vanadium, Wolfram und Titan enthält und die zweite Gruppe Kupfer, Zink, Zirkonium, Tantal, Niob, Aluminium, Bor und Hafnium enthält.

Im Folgenden wird die Erfindung anhand der Zeichnungen näher beschrieben. Es zeigen:
- Fig. 1: eine stark schematisierte Skizze einer Beschichtungseinrichtung,

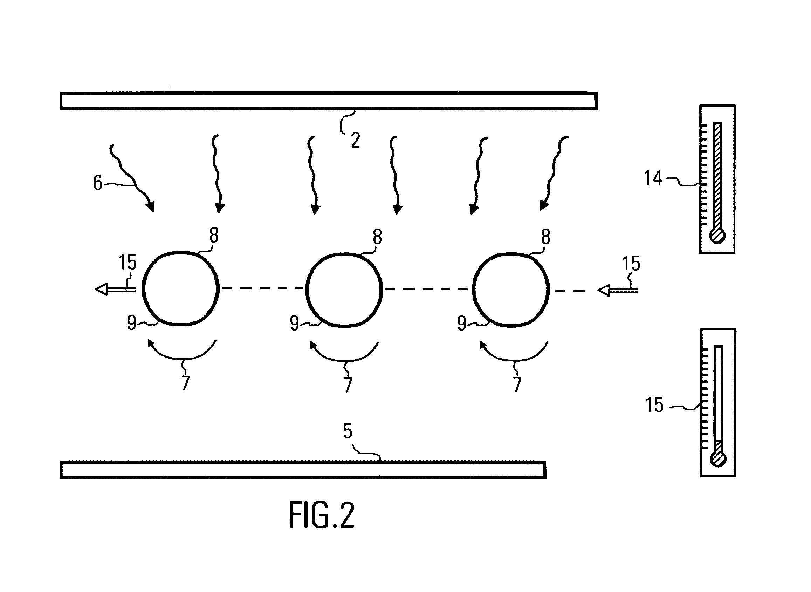

- Fig. 2: eine stark schematisierte Prinzipskizze des Beschichtungsverfahrens,
- Fig. 3: eine schematische Darstellung eines ternären Phasendiagramms.

Die gewünschte Härte der Hartstoffschicht wird durch die Mischung eines Nichtmetalls mit zwei unterschiedlichen Metallen erreicht, wobei sich die Metalle maßgeblich in ihrer Kristallisationsstruktur unterscheiden. Das heißt, bei gleichen Aktivierungsbedingungen, beispielsweise einem Plasma und bei gleichen Reaktionsgaszusammensetzungen bilden die beiden Metalle unterschiedliche Kristallgitter aus. Es ergibt sich dadurch ein Kristallmissmatch mit Mischungslücken, wodurch Aufhärtungsmechanismen greifen, die die Härte der Hartstoffschicht erhöhen. Des Weiteren ergibt sich eine extreme Kornfeinung und eine oberflächliche Reibungsreduzierung. Die erfindungsgemäße Hartstoffschicht weist deshalb einerseits eine verbesserte Härte gegenüber den bisher bekannten Hartstoffbeschichtungen und zusätzlich eine reduzierte Reibung auf ihrer Oberfläche auf. Entsprechend ist die Hartstoffschicht sehr verschleißbeständig und hat ausserdem sehr gute Reibwerte.

Als weitere Wirkung ergibt sich eine tribochemische Schmierwirkung der Schichtwerkstoffe unter den Betriebsbedingungen eines Verbindungsmotors. Dies bedeutet, dass die erfindungsgemäße Hartstoffschicht zusammen mit dem Motoröl bzw. den Additiven im Motoröl optimal zusammenarbeitet, um die Reibung im Kettengelenk zu verringern.

Die in der Hartstoffschicht erzielten Kristallstrukturen hängen maßgeblich von den lonengrößen der gewählten Stoffe ab. Dieser lonenradius ist im Wesentlichen nicht stoff- bzw. materialabhängig, sondern prozessabhängig. Der lonenradius resultiert aus dem lonisierungsgrad des Materials, wobei das Verhältnis der lonenradien der Stoffe die Kristallstruktur (z.B. kubisch, hexagonal, tetragonal) über den Grenzradienansatz r+/r- bestimmt. Um eine möglichst harte und verschleißbeständige Hartstoffschicht zu erreichen ist es das Ziel hier immer unterschiedliche Kristallstrukturen zusammen zu paaren. So entstehen für r+/r- zwischen 1 und 0,73 Kristallstrukturen in der Ausprägung kubisch, bis 0,41 oktaedrisch und r+/r- bis 0,2 Kristallstrukturen in der Ausprägung tetraedrisch. Beispiele für mögliche Stoffkombinationen sind:
(V,Ta)C
(V,Nb)C
(V,Hf)C
(Cr,Zr)N
(Cr,Mo)N
(Cr,W)N
(Cr,Cu)N
(Mo,Cu)N
(W,Cu)N
(Mo,V)N
(Cr,V)N
(V,Nb)N
(Ti,Nb)N

Die genannten Stoffkombinationen können als Varianten mit C, Cn, SiN oder SiC vorliegen. Die Reihenfolge der Stoffe bzw. die Mengenverhältnisse der beiden Metalle sind grundsätzlich austauschbar.

Abhängig vom Mengenverhältnis zwischen dem ersten Metall und dem zweiten Metall dominiert das in größerer Menge vorhandene Metall die Hauptstruktur, d.h. z.B. für eine Gradierung kann ein Wechsel des dominanten Metalls vorgesehen sein.

Des Weiteren sind folgende Phasen in den Schichten denkbar (lediglich Sammlung an Beispielen):
CrN₁₋ₓ -MoN_{1-y}-SiₐN_{b}
CrN₁₋ₓ -WN_{1-y}
CrCN₁₋ₓ-WCN_{1-y}
CrN₁₋ₓ-MoN_{1-y} -SiC
MoN₁₋ₓ -CuN_{1-y}
CrN₁₋ₓ -CuN_{1-y}
CrN₁₋ₓ -ZrCN_{1-y}
ZrN₁₋ₓ -CuN_{1-y}
MoCu-MoN₁₋ₓ

Diese Schichten können als Gradientenschichten und/oder Multilayerschichten und/oder Nanocompositschichten ausgebildet sein. Als Multilayerschicht ist dabei zu verstehen, dass mehrere Schichten vorgesehen sind, die aus unterschiedlichen Stoffkombinationen aufgebaut sind. Daneben können ebenso Gradientenschichten vorgesehen sein oder eine Mischung hieraus, wobei sich die Schichtzusammensetzung nur graduell verändert und keine klare Abgrenzung zwischen unterschiedlichen Schichten vorgenommen werden kann. Als Nanocompositschicht ist eine Schicht zu verstehen, deren Struktur von einem Hauptmaterial gebildet ist, in das ein oder mehrere Stoffe in geringer Menge eingebracht sind. Beispielsweise könnte eine Nanocompositschicht aus CrN -MoN-SiN gebildet sein, wobei SiN die Grundstruktur, bzw. die Matrix bildet und CrN und MoN in geringer Menge, bevorzugt als Nanopartikel eingelagert sind.

Des Weiteren ergibt sich durch die Aufbringung der Hartstoffschicht und deren Eigenschaften, dass die Oberfläche der Hartstoffschicht glasähnlich aufgebaut ist. Entsprechend ist die Oberfläche sehr reibungsarm mit einer hohen Härte und Widerstandskraft.

Die Hartstoffschicht kann in einem stöchiometrischen Übergangsstadium vorliegen. Hiermit ist gemeint, dass z.B. der Kohlenstoff- oder Siliziumanteil in einer im Nanoscale dispersen Phase, also fein verteilt im geringen Maßstab, vorliegt.

Die Hartstoffschicht wird in einem PVD-Verfahren, insbesondere bevorzugt in einem Plasma-PVD-Prozess aufgebracht. Hierbei ergibt sich eine sogenannte CVD-ähnliche Prozessunterstützung, da die nicht-metallischen Stoffe Kohlenstoff, Stickstoff und Silizium während des PVD-Prozesses zu einem gewissen Grad an chemischen Reaktionen beteiligt sind, die aus dem eigentlich reinen PVD-Prozess einen PVD-Prozess mit Elementen der CVD-Prozesse macht.

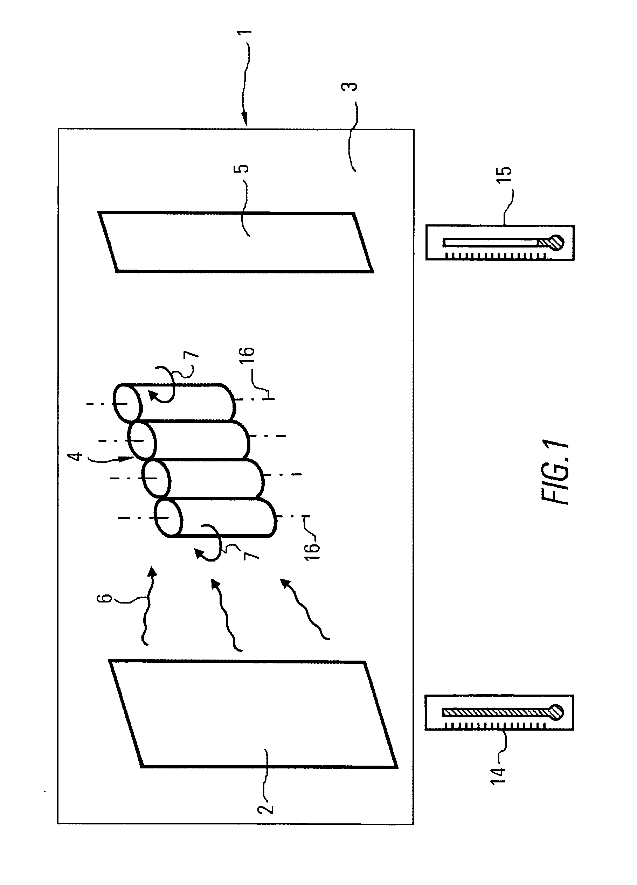

Wie bereits angesprochen, beruhen die erzielbaren Kristallstrukturen im Wesentlichen auf den ausgewählten Materialkombinationen. Daneben sind die entstehenden Kristallstrukturen aber zu einem gewissen Grad auch durch die Prozessführung beeinflussbar. Die Beschichtungsanlage 1 (Fig. 1) ist deshalb derart aufgebaut, dass die Prozessführung die Bildung unterschiedlicher Kristallstrukturen unterstützt. Hierzu ist in der Beschichtungskammer 3 mindestens ein Target 2, die zu beschichtenden Bauteile, d.h. die Bolzen 4, sowie gegebenenfalls eine Kühleinrichtung 5 vorgesehen. Nicht gezeigt ist eine Transportvorrichtung für die Bolzen 4, die diese durch die Beschichtungskammer 3 transportiert. Der Transport erfolgt durch die Prozesskammer 3 im Durchlaufverfahren (angedeutet mittels der Pfeile 15). Dabei rotieren die Bolzen 4 bevorzugt um ihre Längsachse 16.

Während des PVD-Prozesses werden aus dem Target 2 Stoffe gelöst, die sich in einem Teilchenstrom 6 in Richtung der Bolzen 4 bewegen und sich auf deren Oberfläche niederschlagen. Ein Niederschlag der Teilchen erfolgt in der Regel lediglich auf der Oberfläche der Bolzen, die dem Target zugewandt ist. Um eine gleichmäßige Beschichtung der Bolzen 4 zu erreichen, werden diese deshalb rotierend durch die Beschichtungskammer 3 geführt, was durch die Pfeile 7 angedeutet ist. Entsprechend wird die gesamte Oberfläche der Bolzen 4 dem Teilchenstrom 6 ausgesetzt, so dass ein gleichmäßiger Niederschlag erreicht wird. Sofern gewünscht, können die Bolzen auch bereichsweise abgedeckt oder auf andere Weise dem Teilchenstrom entzogen sein, so dass sich nur auf den gewünschten Oberflächen eine Hartstoffbeschichtung ergibt.

Allen PVD-Verfahren ist gemein, dass eine gewisse Hitze bzw. Erhitzung des Targets notwendig ist, um einen Teilchenstrom 6 zu generieren. Die Hitze, bzw. hohe Temperatur ist dabei notwendig, um eine ausreichend hohe Teilchenenergie zu erreichen, die ein Lösen der Teilchen aus dem Target bewirkt. Entsprechend sind die dem Target 2 zugewandten Seiten 8 der Bolzen 4 einer höheren Temperatur ausgesetzt als die dem Target abgewandten Seiten 9 der Bolzen. Entsprechend könnte man die Seiten 8 und 9 auch als Tagseite 8 sowie als Nachtseite 9 bezeichnen. Es ergibt sich dadurch, dass die Tagseiten 8 der Bolzen 4 eine höhere Temperatur aufweisen als die Nachtseiten 9, was wiederum Einfluss auf die erzielbaren Kristallstrukturen hat. Die Temperatur ist in den Figuren mittels schematisierten Thermometern für hohe Temperatur 14 und niedrige Temperatur 15 angedeutet.

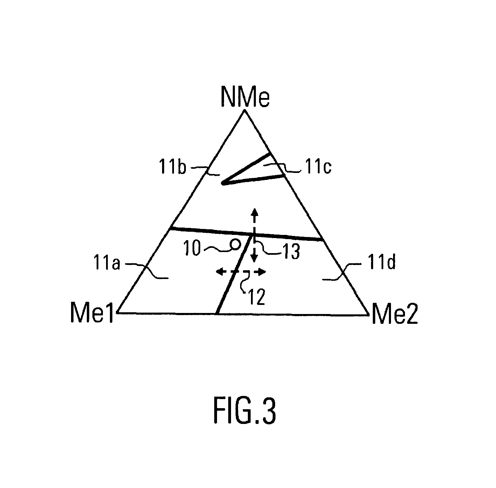

Wie in Fig. 3 gezeigt, gelten für Stoffkombinationen mit drei Stoffen sogenannte ternäre Phasendiagramme. Im gezeigten Beispiel sind die drei Stoffe ein Nichtmetall (NMe), ein erstes Metall (Me1) und ein zweites Metall (Me2). Dabei ergeben sich abhängig von den Mengenverhältnissen sowie den zugehörigen Prozessbedingungen, insbesondere der Temperatur, unterschiedliche Kristallstrukturen. Das ternäre Phasendiagramm der Fig. 3 dient hier nur der prinzipiellen Darstellung und bezieht sich nicht auf zuvor genannte Stoffkombinationen.

Im Phasendiagramm der Figur 3 sind mehrere Bereiche 11a, 11 b, 11 c, 11 d gekennzeichnet, die jeweils unterschiedliche Kristallisationsstrukturen markieren. Im gezeigten Beispiel befindet sich der Stöchiometriepunkt 10 einer Schicht bzw. Materialkombination nahe der Grenze von Bereich 11 a zu den Bereichen 11 b und 11 d.

Der Stöchiometriepunkt 10 ist üblicherweise nur vergleichsweise langsam veränderbar, weshalb sich für die Beeinflussung der Hartstoffschicht andere Prozessparameter, wie z.B. die Temperatur anbieten. Durch Änderung der Reaktions- bzw. Prozessbedingungen am bewegten Teil ist es deshalb möglich, die Phasengrenzen zwischen den Bereichen 11a, 11 b, 11 c und 11 d derart zu verschieben, dass sich die Phasengrenzen über den Stöchiometriepunkt 10 hinweg verschieben. Die Verschiebung der Phasengrenzen zwischen den Bereichen 11a, 11b, 11c, 11 d ist in Figur 3 mit den Pfeilen 12 und 13 angedeutet. Wie bereits angesprochen, bilden sich Kristallstrukturen oft in Abhängigkeit vom Energieangebot, d.h. der Temperatur aus. Sofern also z.B. eine Schicht abgeschieden wird, die sich aus kubischem MoN₁₋ₓ sowie CrN_{1-y} zusammensetzt, kann mittels einer Temperaturänderung das kubische MoN₁₋ₓ zu hexagonalem MoN₁₋ₓ wechseln, wobei die CrN_{1-y} Phase stabil bleibt. Prinzipiell kann sich eine oder zwei Einzelphasen einer Schicht verändern, also eine oder zwei Phasengrenzen verschieben.

Die hierzu notwendigen zu verändernden Reaktionsbedingungen sind abhängig von den gewählten Stoffkombinationen und können deshalb hier nicht allgemeingültig wiedergegeben werden. Mögliche Maßnahmen der Einflussnahme sind jedoch beispielsweise die Veränderung der Temperatur oder des Mischungsverhältnisses.

Zusätzlich kann der Wechsel auf die andere Seite der Phasengrenze auch noch forciert werden durch die Verschiebung des Stöchiometriepunktes, beispielsweise, wenn man die Zufuhr des Reaktionsgases, d.h. des Nichtmetalls variiert.

Die gezeigte Beschichtungsanlage 1 weist zur Einflussnahme auf die Temperatur der Bolzen 4 im Beschichtungsraum eine Kühlvorrichtung 5 auf. Während der Rotation der Bolzen 4 gelangt ein Bereich der Oberfläche in den sogenannten Nachtbereich 9, wo dieser abkühlt.

Entsprechend ergibt sich bei der Wahl der jeweiligen Stoffkombination und der zugehörigen Temperaturen eine unterschiedliche Kristallstruktur. Die Kühlung kann deshalb derart angepasst werden, dass immer der gewünschte Umschlagbereich zwischen zwei Kristallstrukturen erreicht wird. Abhängig von den gewählten Materialkombinationen ist es auch möglich, dass keine zusätzliche Kühlung notwendig ist und allein die geringfügig niedrigere Temperatur durch den größeren Abstand des Nachtbereichs zum beheizten Target ausreicht. Bevorzugt sind aber steile Temperaturgradienten, d.h. eine schnelle und wesentliche Änderung der Temperatur.

Während des Beschichtungsvorganges wandert ein Punkt auf der Oberfläche des Bolzens von der Nachtseite sozusagen durch eine Dämmerungszone in die Tagseite und erneut in eine Dämmerungszone in die Nachtseite. Entsprechend beginnt sich die Oberfläche des Bolzens ab dem Übergang in die Dämmerungszone zu erhitzen, bis sie in der Tagseite einen maximalen Wert erreicht und beim Übergang in die Dämmerungszone erneut abkühlt. Die Temperatur der Bolzenoberfläche unterliegt deshalb einem stetigen Wandel, weshalb auch die darauf abgeschiedene Hartstoffschicht unterschiedliche Strukturen ausbilden kann.

Für derartige Beschichtungen eignet sich insbesondere ein Basiswerkstoff aus Crlegiertem Stahl, z.B. 59CrV4, 100Cr6 oder höherlegiert. Die Beschichtungstemperaturen liegen bevorzugt im Bereich von 100°C bis 500°C, wobei Schichtdicken von 1 bis 10 µm angestrebt sind. Einzelne Schichtlagendicken können kleiner als 0,5 µm sein. Die gradierten Korngrößen können 50 nm oder kleiner sein.

Bei der Nutzung von Stickstoff und Silizium als Nichtmetallpartner ist eine Härte im Bereich von 2000 bis 4000 HV erzielbar. Im Fall von Kohlenstoff als Nichtmetallpartner sind ebenfalls 2000 bis 4000 HV erreichbar, wobei allerdings auch Werte von 4000 bis 7000 HV zu erreichen sind.

Zusammengefasst lässt sich sagen, dass die einseitige Anordnung der Beschichtungsquelle zu den Produkten und die Kühlung der Produkte von der anderen Seite und die Rotation der Bolzen schnelle Erhitzungs- und Abkühlvorgänge an der Bolzenoberfläche erlauben. Ein virtueller Beobachtungspunkt auf der Bolzenoberfläche wandert von der heißesten Disposition direkt gegenüber der Quelle (d.h. dem Target) in Richtung des Beschichtungshorizonts, wo der Energieeintrag bereits deutlich geringer ist, weiter in den Nachtbereich, wo ein Abkühlvorgang einsetzt, der entweder durch ein aktives Kühlen mit einer Kühleinrichtung oder durch geringere Umgebungstemperaturen hervorgerufen ist. Mit dem Ende des Nachtbereichs beginnt die Wiederaufheizung ab dem Aufgangshorizont. Dies ermöglicht schnellere Änderungen des Arbeitspunktes im ternären Phasenumfeld und des ternären Phasenumfeldes selbst. Die Änderungsgeschwindigkeit ist einstellbar über den Prozess.

Die vorgestellte Hartstoffschicht sowie das Verfahren zum Aufbringen derselben ist für alle Arten von Ketten anwendbar. Insbesondere können damit Hülsenketten und sonstige Arten von Ketten, wie z.B. Zahnketten ausgestattet sein.

## Patentansprüche

1. Gelenkkette aus jeweils mittels eines Kettengelenks miteinander verbundenen Kettengliedern, wobei das Kettengelenk mindestens ein Gelenklager und einen in dem Gelenklager verschwenkbar geführten und mit diesem in Kontakt stehenden Bolzen umfasst,
wobei zumindest eine Lagerfläche des Bolzens und/oder des Gelenklagers mit einer Hartstoffschicht versehen ist, und die Hartstoffschicht mittels eines PVD-Prozesses aufgebracht ist, wobei die Hartstoffschicht aus einer Verbindung gebildet ist, die mindestens ein erstes und ein zweites Metall und ein Nichtmetall umfasst, wobei als Nichtmetall zumindest einer der Stoffe C, N oder Si ausgewählt ist, und das erste Metall und das zweite Metall aus den Stoffen Cr, Mo, V, W, Ti, Cu, Zn, Zr, Ta, Nb, Al, B, Hf ausgewählt sind, wobei sich das erste und das zweite Metall voneinander unterscheiden, **dadurch gekennzeichnet, dass** das erste Metall in der Hartstoffschicht in einer Kristallstruktur vorliegt, die sich von der Kristallstruktur des zweiten Metalls unterscheidet.

2. Gelenkkette nach Anspruch 1, wobei die Hartstoffschicht einen gradierten Aufbau hinsichtlich des Nichtmetallanteils, der Härte oder des Eigenspannungsanteils aufweist.

3. Gelenkkette nach einem der Ansprüche 1 oder 2, wobei als Basiswerkstoff des Bolzens oder des Gelenklagers ein Cr-legierter Stahl, z.B. 59CrV4 oder 100Cr6, gewählt ist.

4. Gelenkkette nach einem der Ansprüche 1 bis 3, wobei die Schichtdicke der Hartstoffschicht 1 bis 15 Mikrometer, bevorzugt 1 bis 10 Mikrometer beträgt.

5. Gelenkkette nach einem der Ansprüche 1 bis 4, wobei eine Schichtlagendicke der Hartstoffschicht weniger als 1 µm, bevorzugt weniger als 0,5 µm beträgt.

6. Gelenkkette nach einem der Ansprüche 1 bis 5, wobei gradierte Korngrößen der Hartstoffschicht eine Größe von kleiner oder gleich 100 nm, bevorzugt von kleiner oder gleich 50 nm aufweisen.

7. Gelenkkette nach einem der Ansprüche 1 bis 6, wobei die Hartstoffschicht zumindest bereichsweise eine glasähnliche Struktur aufweist.

8. Gelenkkette nach einem der Ansprüche 1 bis 7, wobei die gradierten Schichthärten der Hartstoffschicht von 2000 bis 4000 HV oder 4000 bis 7000 HV liegen.

9. Kettenbolzen für eine Gelenkkette, der zumindest bereichsweise mit einer Hartstoffschicht nach einem der Ansprüche 1 bis 8 versehen ist.

10. Verfahren zum Beschichten einer Lagerfläche eines Bolzens und/oder eines Gelenklagers für eine Kette mit einer Hartstoffschicht, wobei die Hartstoffschicht mittels eines PVD-Prozesses aufgebracht ist und aus einer Verbindung gebildet ist, die mindestens ein erstes und ein zweites Metall und ein Nichtmetall umfasst, wobei als Nichtmetall zumindest einer der Stoffe C, N oder Si ausgewählt ist, und das erste Metall und das zweite Metall aus den Stoffen Cr, Mo, W, Ti, Cu, Zn, Zr, Ta, Nb, Al, B, V, Hf ausgewählt sind, wobei sich das erste und das zweite Metall voneinander unterscheiden, **dadurch gekennzeichnet, dass** das erste Metall in der Hartstoffschicht eine Kristallstruktur ausbildet, die sich von der Kristallstruktur des zweiten Metalls unterscheidet.

11. Verfahren zum Beschichten einer Lagerfläche eines Bolzens und/oder eines Gelenklagers für eine Kette mit einer Hartstoffschicht nach Anspruch 10, wobei die Hartstoffschicht in einem gradierten Aufbau aufgebracht ist.

12. Verfahren zum Beschichten einer Lagerfläche eines Bolzens und/oder eines Gelenklagers für eine Kette mit einer Hartstoffschicht nach Anspruch 10 oder 11, wobei der PVD-Prozess als kontinuierlicher Prozess im Durchlaufverfahren abläuft.

13. Verfahren zum Beschichten einer Lagerfläche eines Bolzens und/oder eines Gelenklagers für eine Kette mit einer Hartstoffschicht nach einem der Ansprüche 10 bis 12, **dadurch gekennzeichnet, dass** die zu beschichtenden Bauteile während des Beschichtungsvorgangs derart in einem Beschichtungsraum geführt werden, dass die zu beschichteten Bauteile zumindest bereichsweise im zeitlichen Verlauf unterschiedlichen Temperaturen ausgesetzt sind.

14. Verfahren zum Beschichten einer Lagerfläche eines Bolzens und/oder eines Gelenklagers für eine Kette mit einer Hartstoffschicht nach einem der Ansprüche 10 bis 13, wobei das erste Metall aus einer ersten Gruppe und das zweite Metall aus einer zweiten Gruppe ausgewählt sind, wobei mindestens ein Metall der ersten Gruppe mit mindestens einem Metall der zweiten Gruppe kombiniert ist, und die erste Gruppe Cr, Mo, V, W, Ti enthält und die zweite Gruppe Cu, Zn, Zr, Ta, Nb, Al, B, Hf enthält.

15. Verfahren zum Beschichten einer Lagerfläche eines Bolzens und/oder eines Gelenklagers für eine Kette mit einer Hartstoffschicht nach einem der Ansprüche 10 bis 14, wobei eines der Nichtmetalle C, N oder Si der Reaktionspartner ist.

## Claims

1. Link chain made of chain links that are connected to one another by means of chain joints, whereby a chain joint comprises at least one chain joint bearing and a pin that is guided in the chain joint bearing in such a manner that it can pivot and that is in contact with this chain joint bearing,
wherein at least one bearing surface of the pin and / or of the chain joint bearing is provided with a hard material layer and the hard material layer is applied by means of a PVD process, wherein
the hard material layer is formed from a compound that comprises at least a first and a second metal and a non-metal, wherein selected as the non-metal is at least one of the materials C, N or Si and the first metal and the second metal are selected from the materials Cr, Mo, V, W, Ti, Cu, Zn, Zr, Ta, Nb, Al, B, Hf, wherein the first and the second metal differ from each other,
**characterized in that** the first metal is present in the hard material layer in a crystal structure that differs from the crystal structure of the second metal.

2. Link chain according to Claim 1, wherein the hard material layer has a gradated configuration with regard to the non-metal portion, the hardness or the internal stress portion.

3. Link chain according to one of the Claims 1 or 2, wherein a Cr-alloy steel, e.g., 59CrV4 or 100Cr6, is selected as the base material for the pin or for the chain joint bearing.

4. Link chain according to one of the Claims 1 to 3, wherein the layer thickness of the hard material layer amounts to 1 to 15 micrometres, preferably 1 to 10 micrometres.

5. Link chain according to one of the Claims 1 to 4, wherein a sub-layer thickness of the hard material layer amounts to less than 1 µm, preferably less than 0.5 µm.

6. Link chain according to one of the Claims 1 to 5, wherein the gradated particle sizes of the hard material layer have a size of less than or equal to 100 nm, preferably of less than or equal to 50 nm.

7. Link chain according to one of the Claims 1 to 6, wherein the hard material layer has a glass-like structure at least in areas.

8. Link chain according to one of the Claims 1 to 7, wherein the gradated layer hardness levels of the hard material layer are from 2000 to 4000 HV or 4000 to 7000 HV.

9. Chain pin for a link chain wherein the chain pin is provided at least in areas with a hard material layer according to one of the Claims 1 to 8.

10. Method for coating with a hard material layer a bearing surface of a pin and / or of a chain joint bearing for a chain, wherein the hard material layer is applied by means of a PVD process and is formed from a compound that comprises at least a first and a second metal and a non-metal, wherein at least one of the materials C, N or Si is selected as the non-metal and the first metal and second metal are selected from the materials Cr, Mo, W, Ti, Cu, Zn, Zr, Ta, Nb, Al, B, V, Hf, wherein the first metal and the second metal differ from each other,
**characterized in that** the first metal is present in the hard material layer in a crystal structure that differs from the crystal structure of the second metal.

11. Method for coating with a hard material layer a bearing surface of a pin and / or of a chain joint bearing for a chain according to Claim 10, wherein the hard material layer is applied in a gradated configuration.

12. Method for coating with a hard material layer a bearing surface of a pin and / or of a chain joint bearing for a chain according to Claim 10 or 11, wherein the PVD process runs as a continuous process using the through-feed method.

13. Method for coating with a hard material layer a bearing surface of a pin and / or of a chain joint bearing for a chain according to one of the Claims 10 to 12, **characterised in that** the components to be coated are fed during the coating process in a coating area in such a manner that the components that are to be coated are exposed at least in areas to different temperatures over time.

14. Method for coating with a hard material layer a bearing surface of a pin and / or of a chain joint bearing for a chain according to one of the Claims 10 to 13, wherein the first metal is selected from a first group and the second metal is selected from a second group, wherein at least one metal of the first group is combined with at least one metal of the second group, and the first group includes Cr, Mo, V, W, Ti and the second group includes Cu, Zn, Zr, Ta, Nb, Al, B, Hf.

15. Method for coating with a hard material layer a bearing surface of a pin and / or of a chain joint bearing for a chain according to one of the Claims 10 to 14, wherein one of the non-metals C, N or Si is the reactant.

## Revendications

1. Chaîne articulée constituée de maillons de chaîne reliés mutuellement les uns aux autres respectivement au moyen d'une articulation de chaîne, dans laquelle l'articulation de chaîne comprend au moins un palier d'articulation et un tourillon guidé de manière pivotante dans le palier d'articulation et en contact avec celui-ci,
dans laquelle au moins une surface d'articulation du tourillon et/ou du palier d'articulation est munie d'une couche de matériau dur, et la couche de matériau dur est appliquée à l'aide d'un processus PVD (dépôt physique en phase vapeur),
dans laquelle la couche de matériau dur est constituée d'un composé englobant au moins un premier et un deuxième métal et un non-métal,
dans laquelle le non-métal est choisi parmi au moins l'un des éléments C, N ou Si, et le premier métal et le deuxième métal sont choisis parmi les éléments Cr, Mo, V, W, Ti, Cu, Zn, Zr, Ta, Nb, Al, B, Hf, le premier et le deuxième métal étant différents l'un de l'autre,
**caractérisée en ce que**
le premier métal est présent dans la couche de matériau dur sous la forme d'une structure cristalline, qui est différente de la structure cristalline du deuxième métal.

2. Chaîne articulée selon la revendication 1, dans laquelle la couche de matériau dur présente une configuration graduelle quant à la fraction de non-métal, à la dureté ou à la fraction de contraintes internes.

3. Chaîne articulée selon l'une des revendications 1 ou 2, dans laquelle pour le matériau de base du tourillon ou du palier d'articulation, on choisit un acier allié au chrome, par exemple 59CrV4 ou 100Cr6.

4. Chaîne articulée selon l'une des revendications 1 à 3, dans laquelle l'épaisseur de couche de la couche de matériau dur a une valeur de 1 à 15 micromètre, de préférence de 1 à 10 micromètre.

5. Chaîne articulée selon l'une des revendications 1 à 4, dans laquelle une épaisseur de strate de couche de la couche de matériau dur a une valeur de moins de 1 µm, de préférence de moins de 0,5 µm.

6. Chaîne articulée selon l'une des revendications 1 à 5, dans laquelle des grosseurs de grains graduelles de la couche de matériau dur présentent une grandeur inférieure ou égale à 100 nm, de préférence inférieure ou égale à 50 nm.

7. Chaîne articulée selon l'une des revendications 1 à 6, dans laquelle la couche de matériau dur présente, au moins dans certaines zones, une structure similaire au verre.

8. Chaîne articulée selon l'une des revendications 1 à 7, dans laquelle les duretés de couche graduelles de la couche de matériau dur se situent dans une plage de 2000 à 4000 HV (dureté Vickers) ou de 4000 à 7000 HV.

9. Tourillon de chaîne pour une chaîne articulée, qui est pourvu, au moins dans certaines zones, d'une couche de matériau dur selon l'une des revendications 1 à 8.

10. Procédé destiné à revêtir une surface de palier d'un tourillon et/ou d'un palier d'articulation pour une chaîne, avec une couche de matériau dur, d'après lequel la couche de matériau dur est appliquée à l'aide d'un processus PVD (dépôt physique en phase vapeur) et est constituée d'un composé englobant au moins un premier et un deuxième métal et un non-métal, le non-métal étant choisi parmi au moins l'un des éléments C, N ou Si, et le premier métal et le deuxième métal étant choisis parmi les éléments Cr, Mo, W, Ti, Cu, Zn, Zr, Ta, Nb, Al, B, V, Hf, le premier et le deuxième métal étant différents l'un de l'autre,
**caractérisé en ce que**
le premier métal forme dans la couche de matériau dur une structure cristalline, qui est différente de la structure cristalline du deuxième métal.

11. Procédé destiné à revêtir une surface de palier d'un tourillon et/ou d'un palier d'articulation pour une chaîne, avec une couche de matériau dur, selon la revendication 10, d'après lequel la couche de matériau dur est appliquée selon une configuration graduelle.

12. Procédé destiné à revêtir une surface de palier d'un tourillon et/ou d'un palier d'articulation pour une chaîne, avec une couche de matériau dur, selon la revendication 10 ou la revendication 11, d'après lequel le processus PVD se déroule en tant que processus continu lors du procédé de traitement par passage en continu.

13. Procédé destiné à revêtir une surface de palier d'un tourillon et/ou d'un palier d'articulation pour une chaîne, avec une couche de matériau dur, selon l'une des revendications 10 à 12, d'après lequel, lors de l'opération de revêtement, les pièces à revêtir sont menées à travers une chambre de revêtement de manière à ce que ces pièces soient soumises, au moins par secteurs, à des températures différentes au cours du temps.

14. Procédé destiné à revêtir une surface de palier d'un tourillon et/ou d'un palier d'articulation pour une chaîne, avec une couche de matériau dur, selon l'une des revendications 10 à 13, d'après lequel le premier métal est choisi parmi un premier groupe de métaux et le deuxième métal parmi un deuxième groupe de métaux, au moins un métal du premier groupe étant combiné avec au moins un métal du deuxième groupe, et le premier groupe comprenant Cr, Mo, V, W, Ti et le deuxième groupe comprenant Cu, Zn, Zr, Ta, Nb, Al, B, Hf.

15. Procédé destiné à revêtir une surface de palier d'un tourillon et/ou d'un palier d'articulation pour une chaîne, avec une couche de matériau dur, selon l'une des revendications 10 à 14, d'après lequel l'un des non-métaux C, N ou Si est le partenaire de réaction.
